Europäisches Patentamt

European Patent Office

Office européen des brevets

(19)

(11) **EP 1 416 575 A1**

(12) **DEMANDE DE BREVET EUROPEEN**

(43) Date de publication:
**06.05.2004 Bulletin 2004/19**

(51) Int Cl.⁷: **H01P 5/10**, H03H 7/42

(21) Numéro de dépôt: **03300168.6**

(22) Date de dépôt: **17.10.2003**

(84) Etats contractants désignés:
**AT BE BG CH CY CZ DE DK EE ES FI FR GB GR HU IE IT LI LU MC NL PT RO SE SI SK TR**
Etats d'extension désignés:
**AL LT LV MK**

(30) Priorité: **30.10.2002 FR 0213611**

(71) Demandeur: **STMicroelectronics S.A.**
**92120 Montrouge (FR)**

(72) Inventeur: **Ezzeddine, Hilal**
**37000 Tours (FR)**

(74) Mandataire: **de Beaumont, Michel**
**1bis, rue Champollion**
**38000 Grenoble (FR)**

(54) **Transformateur à changement de mode**

(57) L'invention concerne un transformateur à changement de mode comportant une première ligne (5, 6) en mode commun et une deuxième ligne (7, 8) en mode différentiel, chaque ligne comprenant deux tronçons en série respectivement couplés avec un des deux tronçons de l'autre ligne et tous les tronçons ayant les mêmes longueurs, et la ligne de mode commun étant connectée en série avec un condensateur (C), pour abaisser la fréquence centrale de la bande passante du transformateur, les longueurs en $\lambda/4$ des tronçons étant choisies pour correspondre à une fréquence centrale supérieure à la fréquence centrale souhaitée pour le transformateur.

Fig 3

EP 1 416 575 A1

**Description**

La présente invention concerne le domaine des transformateurs à changement de mode qui sont utilisés pour convertir une tension de mode commun en mode différentiel et inversement.

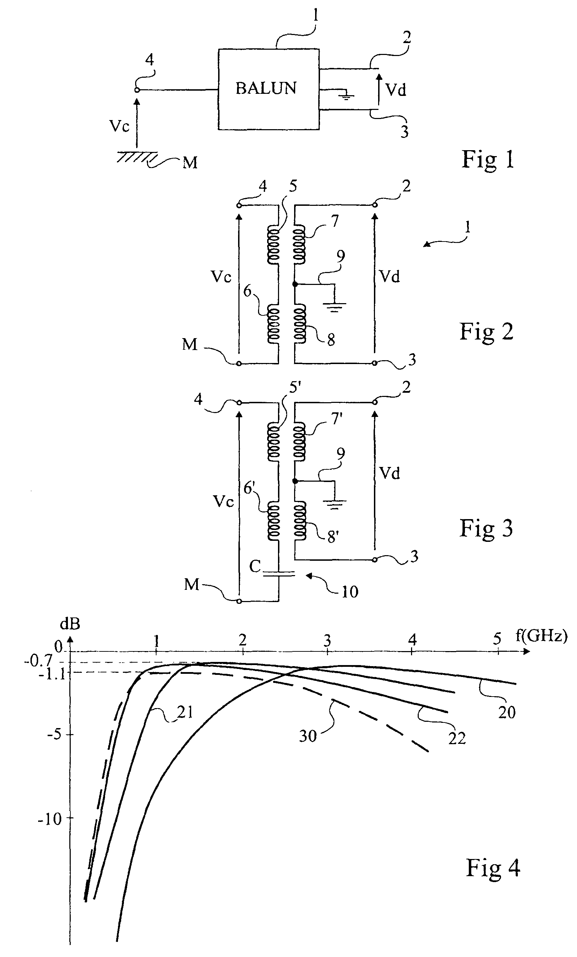

La figure 1 illustre, de façon très schématique et sous forme de blocs, un tel transformateur du type auquel s'applique la présente invention.

Il s'agit d'une structure de conversion d'une tension Vc de mode commun référencée à la masse M ou à la terre en une tension différentielle Vd fournie entre deux bornes 2, 3 de sortie. Une borne 4 d'entrée-sortie de mode commun est, par exemple, en l'air (dans une application à la réception de signaux radiofréquence).

L'invention concerne plus particulièrement de tels convertisseurs dits distribués (généralement dénommés BALUN) réalisés à partir de pistes conductrices couplées. De tels convertisseurs sont dits de type Marchand et ils sont connus pour être large bande.

La figure 2 représente le schéma électrique d'un transformateur à changement de mode de type Marchand auquel s'applique la présente invention. Côté mode commun (entrée 4 et masse M), un premier enroulement constitué de deux sections 5 et 6 de spires conductrices est couplé avec un deuxième enroulement constitué toujours de deux sections 7 et 8 côté mode différentiel. Les sections 7 et 8 sont électriquement en série entre les bornes 2 et 3 et présentent un point milieu 9 constituant la masse du mode différentiel (éventuellement isolée de la masse du mode commun). Les longueurs des différents enroulements sont toutes identiques, ce qui caractérise un convertisseur de type Marchand. Ces longueurs sont toutes égales à λ/4, où λ correspond à la longueur d'onde de la fréquence centrale de la bande passante du convertisseur considéré.

La relation qui lie la longueur d'onde λ et la fréquence est la suivante :

λ = c/f√ε, où c représente la célérité de la lumière dans le vide, où ε représente la permittivité du substrat et où f représente la fréquence (ici la fréquence centrale de la bande passante souhaitée).

Dans un convertisseur du type de la figure 2, cette fréquence centrale est définie comme étant la fréquence médiane de la bande passante correspondant à ±3dB par rapport à l'atténuation minimum du transformateur.

Un exemple de transformation de changement de mode de type Marchand auquel s'applique la présente invention est décrit, par exemple, dans l'article "A Silicon Monolithic Transmission Balun with Symetrical Design" de Yeong J. et Yichenglu, paru dans IEEE Electron devices letters, volume 20, n°4 en avril 1999.

Un inconvénient des transformateurs à changement de mode constitués de pistes conductrices sur des niveaux de métallisations différents dans des structures intégrées est lié à la taille occupée par ces transformateurs. Par exemple, pour des fréquences de l'ordre du gigahertz, il est fréquent de devoir dimensionner les lignes avec des longueurs de plusieurs centimètres, ce qui est loin d'être négligeable dans l'encombrement d'un circuit intégré ou imprimé.

Une autre difficulté réside dans le fait que, plus les tronçons sont longs, plus les pertes d'insertion sont élevées. Or, dans des applications intégrées (par exemple, la téléphonie mobile), les signaux reçus sont souvent de faible intensité et il faut donc minimiser les pertes d'insertion.

La présente invention vise à proposer une nouvelle structure de transformateur à changement de mode, d'encombrement moindre que des structures classiques pour une même fréquence centrale.

L'invention vise également à proposer un tel transformateur qui puisse être réalisé en appliquant des technologies du type de celles utilisées dans la fabrication des circuits intégrés.

L'invention vise également à proposer une solution qui diminue les pertes d'insertion.

Pour atteindre ces objets et d'autres, la présente invention prévoit un transformateur à changement de mode comportant une première ligne en mode commun et une deuxième ligne en mode différentiel, chaque ligne comprenant deux tronçons en série respectivement couplés avec un des deux tronçons de l'autre ligne et tous les tronçons ayant les mêmes longueurs, la ligne de mode commun étant connectée en série avec un condensateur, pour abaisser la fréquence centrale de la bande passante du transformateur, les longueurs en λ/4 des tronçons étant choisies pour correspondre à une fréquence centrale supérieure à la fréquence centrale souhaitée pour le transformateur.

Selon un mode de réalisation de la présente invention, la valeur du condensateur C respecte la relation suivante :

$$C = \frac{1}{2\pi f_0 Z_c \, tg(\beta L)},$$

où $f_0$ désigne la fréquence centrale de la bande passante souhaitée, où L désigne la longueur de deux tronçons en série calculée en λ/2 à partir de ladite fréquence centrale supérieure à la fréquence centrale souhaitée, où $Z_C$ désigne l'impédance caractéristique de la ligne, et où β désigne la constante de phase.

Selon un mode de réalisation de la présente invention, chaque tronçon est un enroulement plan, deux premiers tronçons étant réalisés dans un premier niveau conducteur d'un circuit multicouches en étant latéralement espacés, les deux autres tronçons étant également réalisés dans le premier niveau conducteur en étant respectivement entrelacés avec les premiers tronçons, au moins une première armature du condensateur étant réalisée dans ledit premier niveau conducteur et des connexions étant réalisées dans un deuxième niveau conducteur.

Selon un mode de réalisation de la présente invention, le condensateur est disposé au milieu d'un des enroulements.

Selon un mode de réalisation de la présente invention, le transformateur est réalisé dans deux niveaux conducteurs séparés par un diélectrique, deux tronçons et une armature du condensateur étant tracés dans chaque niveau de métallisation.

Selon un mode de réalisation de la présente invention, le transformateur est appliqué à des fréquences de l'ordre du gigahertz.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :

la figure 1, décrite précédemment, représente le schéma bloc d'un transformateur à changement de mode du type auquel s'applique la présente invention ;
la figure 2 représente le schéma électrique équivalent d'un transformateur à changement de mode classique ;
la figure 3 représente le schéma électrique équivalent d'un transformateur à changement de mode selon la présente invention ; et
la figure 4 représente différentes courbes de réponse d'un transformateur à changement de mode selon la présente invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, l'origine et la destination des signaux convertis par le transformateur à changement de mode n'ont pas été détaillées et ne font pas l'objet de l'invention. Celle-ci s'applique quel que soit le type de signaux devant être traités. De plus, la réalisation pratique des pistes conductrices n'a pas été détaillée, l'invention pouvant être mise en oeuvre en appliquant des technologies courantes.

Une caractéristique de l'invention est d'insérer, entre une des extrémités de l'enroulement de mode commun et la masse, un condensateur. Ce condensateur permet de réduire la fréquence centrale de la bande passante du transformateur réalisé, alors même que ses enroulements sont dimensionnés pour des fréquences de fonctionnement plus élevées, donc avec une longueur plus faible.

La figure 3 représente le schéma équivalent d'un transformateur à changement de mode selon la présente invention. Comme précédemment, un tel convertisseur 10 comporte une entrée de mode commun d'application d'une tension Vc référencée à une masse M sur une première borne 4, et une sortie de mode différentiel entre deux bornes 2 et 3 fournissant une tension Vd.

Du point de vue du schéma, le deuxième enroulement de mode différentiel constitué des tronçons 7' et 8' conducteurs entre lesquels se trouve le point milieu 9 du mode différentiel n'est pas modifié par rapport à un transformateur classique, si ce n'est par les longueurs des tronçons 7' et 8' pour une fréquence centrale de bande passante donnée.

Côté mode commun, l'invention prévoit un condensateur C en série avec les deux tronçons 5' et 6' du premier enroulement.

Une caractéristique de la présente invention est de dimensionner en λ/4 les tronçons conducteurs, fonction de la longueur d'onde centrale λ de la bande passante du transformateur, à partir d'une fréquence sensiblement supérieure à celle pour laquelle est destiné ce transformateur. Puis, par l'introduction du condensateur C, on rabaisse la fréquence de fonctionnement du transformateur vers la bande de fréquences souhaitée.

Un avantage d'une telle structure est qu'en dimensionnant le transformateur pour des fréquences plus élevées, les longueurs respectives des pistes conductrices sont moindres.

Un autre avantage est qu'en diminuant les longueurs des pistes conductrices, on induit une diminution des pertes d'insertion du transformateur ainsi constitué.

Le prix à payer pour la mise en oeuvre de l'invention est une légère dégradation de la bande passante du transformateur (c'est-à-dire de la largeur de bande du transformateur constitué).

La figure 4 illustre la mise en oeuvre de l'invention en représentant plusieurs réponses en fréquence de transformateurs à changement de mode. La figure 4 représente la réponse en fréquence de trois transformateurs à changement de mode ayant des tronçons conducteurs de longueurs identiques et dimensionnés par rapport à une fréquence centrale de 3,5 GHz (courbe 20), respectivement affectés d'un condensateur de 1 picofarad (courbe 21) et d'un condensateur de 2 picofarads (courbe 22).

Comme il ressort de la figure 4, avec un condensateur de 1 picofarad, la fréquence centrale du transformateur est ramenée à environ 1,5 GHz tandis qu'avec un condensateur de 2 picofarads, cette fréquence centrale est encore rabaissée jusqu'à environ 0,9 GHz.

Bien que cela n'apparaisse pas sur la figure, les inventeurs ont noté que les pertes d'insertion respectives des trois transformateurs illustrés par les courbes respectives 20, 21 et 22 sont de -0,6 dB, -0,7 dB, et -0,9 dB. Les pertes d'insertion augmentent donc légèrement avec l'introduction du condensateur C. Toutefois et comme l'illustre la courbe en pointillés 30 de la figure 4, pour réaliser un transformateur à une fréquence centrale de 1,5 GHz sans condensateur, les pertes d'insertion seraient nettement supérieures (-1,1 dB). Par conséquent, l'adjonction d'un condensateur par rapport à un transformateur dimensionné pour une fréquence supérieure conduit bien à une diminution des pertes d'insertion par rapport à un transformateur classique.

Dans l'exemple de la figure 4, le transformateur a été réalisé sur un substrat de verre avec deux spirales dans des niveaux de métallisation en cuivre, isolés l'un de l'autre par un diélectrique. Dans une telle réalisation, un transformateur dimensionné pour fonctionner à 1,5 GHz (courbe 30, figure 4) occuperait une surface de 3,2 x 1,6 mm$^2$. Un transformateur dimensionné pour fonctionner à une fréquence de 3,5 GHz occupe une surface de 2 x 1,1 mm$^2$. De plus, la réalisation du condensateur est particulièrement aisée et ne requiert aucun niveau supplémentaire. En effet, on peut utiliser le diélectrique et les deux niveaux de métallisation pour ses armatures.

Par exemple, chaque tronçon est un enroulement plan formé dans un niveau conducteur d'un circuit multicouches. Les deux tronçons d'une première ligne (de préférence 5' et 6') sont placés côte à côte et reliés dans le même niveau. Les deux tronçons 7' et 8' de l'autre ligne sont réalisés en étant respectivement entrelacés avec un des tronçons de la première ligne. Leurs extrémités centrales respectives sont raccordées électriquement à l'extérieur de la structure par des ponts réalisés dans un deuxième niveau conducteur, connectés au premier niveau par des vias, ce qui réalise en outre la connexion de masse 9.

Selon un premier mode de réalisation, le condensateur C est réalisé à l'extérieur de la structure en ayant une de ses armatures dans chacun des deux niveaux conducteurs et en utilisant un pont pour son raccordement à l'extrémité du tronçons 6' qui est au centre d'un des enroulements.

Selon un deuxième mode de réalisation, le condensateur C est disposé au centre des enroulements formant les tronçons 5' et 6'. Ainsi, la connexion de son armature au tronçon 6' s'effectue sans pont. Un autre avantage est que cela minimise la taille globale du transformateur.

En variante, un troisième niveau conducteur est utilisé pour une des armatures du condensateur, que celui-ci soit placé au centre ou à l'extérieur des enroulements.

Un autre avantage de l'invention qui ressort de la figure 4 est qu'avec un même transformateur dimensionné pour une fréquence relativement élevée, on peut modifier la fréquence centrale du transformateur simplement en changeant la valeur du condensateur C. Il en découle une possibilité de créer des modèles de circuits intégrés identiques pour des applications différentes.

Pour la mise en oeuvre de l'invention, on pourra appliquer la relation suivante afin de dimensionner les constituants respectifs du transformateur :

$$C = \frac{1}{2\pi f_0 Z_c \mathrm{tg}(\beta L)},$$

où $f_0$ désigne la fréquence centrale de la bande passante souhaitée, où L désigne la longueur de chaque piste conductrice (longueur cumulée des tronçons 5', 6' et 7', 8') calculée en $\lambda/2$ ($2*\lambda/4$) à partir d'une fréquence plus élevée que la fréquence centrale $f_0$ souhaitée, où $Z_C$ désigne l'impédance caractéristique de la ligne (supposée identique pour chaque enroulement), et où $\beta$ désigne la constante de phase.

L'application de cette relation pour dimensionner un transformateur propre à l'invention est à la portée de l'homme du métier à partir des indications fonctionnelles données ci-dessus et en fonction de son application. Par exemple, on pourra utiliser les techniques décrites dans l'article déjà cité.

Bien entendu, la présente invention est susceptible de diverses variantes et modifications qui apparaîtront à l'homme de l'art. En particulier, les dimensions à donner aux enroulements d'un transformateur à changement de mode selon l'invention, en fonction de la fréquence de fonctionnement souhaitée et du condensateur introduit en série avec le mode commun, est à la portée de l'homme du métier en fonction de l'application et des indications fonctionnelles données ci-dessus. De plus, on notera, que, en pratique, plusieurs transformateurs à changement de mode peuvent être associés en série pour augmenter la bande passante.

**Revendications**

**1.** Transformateur à changement de mode comportant une première ligne (5, 6) en mode commun et une deuxième ligne (7, 8) en mode différentiel, chaque ligne comprenant deux tronçons en série respectivement couplés avec un des deux tronçons de l'autre ligne et tous les tronçons ayant les mêmes longueurs, **caractérisé en ce que** la ligne de mode commun est connectée en série avec un condensateur (C), pour abaisser la fréquence centrale de la bande passante du transformateur, les longueurs en $\lambda/4$ des tronçons étant choisies pour correspondre à une fréquence centrale supérieure à la fréquence centrale souhaitée pour le transformateur.

**2.** Transformateur selon la revendication 1, dans lequel la valeur du condensateur C respecte la relation suivante :

$$C = \frac{1}{2\pi f_0 Z_c \mathrm{tg}(\beta L)},$$

où $f_0$ désigne la fréquence centrale de la bande passante souhaitée, où L désigne la longueur de deux tronçons en série calculée en λ/2 à partir de ladite fréquence centrale supérieure à la fréquence centrale souhaitée, où $Z_C$ désigne l'impédance caractéristique de la ligne, et où β désigne la constante de phase.

3. Transformateur selon la revendication 1, dans lequel chaque tronçon est un enroulement plan, deux premiers tronçons (5', 6') étant réalisés dans un premier niveau conducteur d'un circuit multicouches en étant latéralement espacés, les deux autres tronçons (7', 8') étant également réalisés dans le premier niveau conducteur en étant respectivement entrelacés avec les premiers tronçons, au moins une première armature du condensateur étant réalisée dans ledit premier niveau conducteur et des connexions étant réalisées dans un deuxième niveau conducteur.

4. Transformateur selon la revendication 3, dans lequel le condensateur (C) est disposé au milieu d'un des enroulements.

5. Transformateur selon l'une quelconque des revendications 1 à 4, réalisé dans deux niveaux conducteurs séparés par un diélectrique, deux tronçons et une armature du condensateur étant tracés dans chaque niveau de métallisation.

6. Transformateur selon l'une quelconque des revendications 1 à 5, appliqué à des fréquences de l'ordre du gigahertz.

Fig 1

Fig 2

Fig 3

Fig 4

EP 1 416 575 A1

**Office européen des brevets**

**RAPPORT DE RECHERCHE EUROPEENNE**

Numéro de la demande

EP 03 30 0168

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 1 227 537 A (BROADCOM CORP) 31 juillet 2002 (2002-07-31) | 1,6 | H01P5/10 H03H7/42 |
| A | * alinéa '0038! * <br> * alinéa '0045! * <br> * alinéa '0048! * <br> * alinéa '0053!; figures 1B,4A,5A * | 2,5 | |
| X | US 5 644 272 A (DABROWSKI JERZY) 1 juillet 1997 (1997-07-01) | 1,6 | |
| A | * colonne 2, ligne 43 - colonne 5, ligne 20; figures * | 2,5 | |
| X | EP 0 866 513 A (NOKIA MOBILE PHONES LTD) 23 septembre 1998 (1998-09-23) | 1 | |
| A | * colonne 3, ligne 34 - colonne 4, ligne 9; figure 2 * | 2 | |
| A | US 5 497 137 A (FUJIKI YASUHIRO) 5 mars 1996 (1996-03-05) * colonne 3, ligne 60 - colonne 6, ligne 13; figures 1-3 * | 1,2,5,6 | |
| | | | **DOMAINES TECHNIQUES RECHERCHES (Int.Cl.7)** |
| A | US 5 477 204 A (LI RICHARD C) 19 décembre 1995 (1995-12-19) * colonne 1, ligne 55 - colonne 2, ligne 51; figure 1 * | 1,3 | H01P H03H |
| A | US 4 369 557 A (VANDEBULT JAN) 25 janvier 1983 (1983-01-25) * abrégé; figures * | 1,3 | |

-/--

Le présent rapport a été établi pour toutes les revendications

| Lieu de la recherche | Date d'achèvement de la recherche | Examinateur |
|---|---|---|
| LA HAYE | 13 février 2004 | Marti Almeda, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

7

**Office européen
des brevets**

## RAPPORT DE RECHERCHE EUROPEENNE

Numéro de la demande

EP 03 30 0168

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,A | YOON Y J ET AL: "A SILICON MONOLITHIC SPIRAL TRANSMISSION LINE BALUN WITH SYMMETRICAL DESIGN" IEEE ELECTRON DEVICE LETTERS, IEEE INC. NEW YORK, US, vol. 20, no. 4, avril 1999 (1999-04), pages 182-184, XP000805728 ISSN: 0741-3106 * le document en entier * ----- | 1,3 | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| LA HAYE | 13 février 2004 | Marti Almeda, R |

**ANNEXE AU RAPPORT DE RECHERCHE EUROPEENNE
RELATIF A LA DEMANDE DE BREVET EUROPEEN NO.**

EP 03 30 0168

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

13–02–2004

| Document brevet cité au rapport de recherche | | Date de publication | Membre(s) de la famille de brevet(s) | | Date de publication |
|---|---|---|---|---|---|
| EP 1227537 | A | 31–07–2002 | US | 2002097107 A1 | 25–07–2002 |
| | | | EP | 1227537 A2 | 31–07–2002 |
| US 5644272 | A | 01–07–1997 | AU | 727581 B2 | 14–12–2000 |
| | | | AU | 1949897 A | 22–09–1997 |
| | | | BR | 9707910 A | 27–07–1999 |
| | | | CN | 1216637 A | 12–05–1999 |
| | | | DE | 69725968 D1 | 11–12–2003 |
| | | | EE | 3360 B1 | 15–02–2001 |
| | | | EP | 0885469 A1 | 23–12–1998 |
| | | | JP | 2000506344 T | 23–05–2000 |
| | | | WO | 9733337 A1 | 12–09–1997 |
| EP 0866513 | A | 23–09–1998 | FI | 971165 A | 21–09–1998 |
| | | | EP | 0866513 A2 | 23–09–1998 |
| | | | US | 6018277 A | 25–01–2000 |
| US 5497137 | A | 05–03–1996 | JP | 2773617 B2 | 09–07–1998 |
| | | | JP | 7176918 A | 14–07–1995 |
| US 5477204 | A | 19–12–1995 | AUCUN | | |
| US 4369557 | A | 25–01–1983 | DE | 3174181 D1 | 30–04–1986 |
| | | | EP | 0059723 A1 | 15–09–1982 |
| | | | WO | 8200541 A1 | 18–02–1982 |

EPO FORM P0460

Pour tout renseignement concernant cette annexe : voir Journal Officiel de l'Office européen des brevets, No.12/82